Europäisches Patentamt

European Patent Office

Office européen des brevets

(19)

(11) Publication number: **0 143 600 B1**

(12)

# EUROPEAN PATENT SPECIFICATION

(45) Date of publication of patent specification: **20.02.91**  (51) Int. Cl.⁵: **G11C  19/28**

(21) Application number: **84308063.1**

(22) Date of filing: **21.11.84**

(54) A circuit for detecting signal charges transferred in a charge transfer device.

(30) Priority: **21.11.83 JP 219015/83**
     **20.12.83 JP 240309/83**

(43) Date of publication of application:
     **05.06.85 Bulletin  85/23**

(45) Publication of the grant of the patent:
     **20.02.91 Bulletin  91/08**

(84) Designated Contracting States:
     **DE FR GB**

(56) References cited:
     **US-A- 3 947 698**
     **US-A- 4 139 784**
     **US-A- 4 355 244**
     **US-A- 4 412 343**

     **IEEE JOURNAL OF SOLID-STATE CIRCUITS,
     vol. SC-9, no. 1, February 1974, pages 1-13,
     New York, US; M.H. WHITE et al.:
     "Characterization of surface channel CCD
     image arrays at low light levels"**

     **IEEE JOURNAL OF SOLID-STATE CIRCUITS,
     vol. SC-12, no. 6, December 1977, pages
     626-632, New York, US; C.H. SEQUIN et al.:
     "Self-contained charge-coupled split-
     electrode filters using a novel sensing tech-**
     **nique"**

(73) Proprietor: **NEC CORPORATION
     7-1, Shiba 5-chome Minato-ku
     Tokyo 108-01(JP)**

(72) Inventor: **Miwada, Kazuo c/o NEC Corporation
     33-1 Shiba 5-chome
     Minato-ku Tokyo(JP)**

(74) Representative: **Pritchard, Colin Hubert et al
     Mathys & Squire 10 Fleet Street
     London EC4Y 1AY(GB)**

## Description

This invention relates to a circuit for detecting signal charges transferred in a charge transfer device such as a charge coupled device (hereinafter, referred to as a CCD), and particularly to an improvement thereof for producing an output signal proportional to a value of signal charges.

Description of the Prior Art:

A CCD linear image sensor has a line of solid-state photosensors in which charges generated in response to a light irradiated therein are accumulated and two charge shift registers arranged in parallel with and disposed on opposite sides of the line of solid-state photosensors. The charges accumulated in alternate photosensors are applied to one charge shift register and those accumulated in the other photosensors are to the other charge shift register. The charges applied to the charge shift registers are transferred in the shift registers toward one ends thereof at which a signal charge detector is formed. The transferred charges are converted into a signal of voltage form in response to their value by the signal charge detector.

The signal charge detector in the prior art has one or two sets of charge-voltage converter and MOS FET circuits. The charge-voltage converter is a P-N junction formed in a semiconductor substrate. The MOS FET circuit is a first stage amplifier receiving the converted voltage, a second stage amplifier amplifying the output of the first stage amplifier, a sampling circuit of the output of the second stage amplifier, an output stage amplifier amplifying the sampled value to output an output signal and a pre-charge FET for charging the charge-voltage converter. Here, it is noted that in the case of using two FET circuits, an output stage amplifier is commonly used for two FET circuits. First, the charge-voltage converter is charged by applying a reset pulse to the pre-charge FET. Thereafter, the transferred charges are introduced to the charge-voltage converter to apply a potential change of the charge-voltage converter to the first stage amplifier and then to the second stage amplifier. The output of the second stage amplifier is sampled in a capacitor in the sampling circuit in response to a sampling pulse. The sampled voltage signal is derived from the output stage amplifier.

The output of the signal charge detector in the prior art is affected by the gate capacitance of the pre-charge FET. When the reset pulse is applied, the charge-voltage converter is charged to a predetermined voltage. However, in response to the removal of the reset pulse, the charged voltage at the charge-voltage converter decreases by a value determined by the gate capacitance. Therefore, if two FET circuits are used in a signal charge detector, since the gate capacitances of the pre-charge FET's have a great deviation due to uncontrollable manufacturing condition, the output voltages from two FET circuits differs from each other.

IEE Journal of Solid State Circuits Vol. SC-9, No. 1, February 1974, pages 1-13 and Vol. SC-12, No. 6, December 1977, pages 626-632 and US-A-4.355.244 disclose signal charge detectors in which the voltage at the input to a second stage amplifier is clamped in order to control the reference level of the output signal.

The output of the signal charge detector in the prior art involves the signal components based on dark current flowing in the CCD shift registers and the solid-state photosensors. This signal components should be subtracted from the output signal to obtain a true output signal which is proportional to signal charges.

It is an object of the present invention to provide a signal charge detector of solid-stage imaging device which produces an output signal having a reference voltage such that the output signal is free from dark current component of the solid-state photosensors.

According to the present invention there is provided a signal charge detector comprising: a charge-voltage converter for receiving charges and producing a signal of voltage form; means for charging said charge-voltage converter to a first predetermined voltage; a first stage amplifier having an input connected to said charge-voltage converter and to said charging means and an output; a second stage amplifier having an input and an output; a clamp circuit connected between said output of said first stage amplifier and said input of said second stage amplifier, said clamp circuit having a capacitor connected between said output of said first stage amplifier and said input of said second stage amplifier, switching means connected between said input of said second stage amplifier and a first terminal for closure in response to a clamping pulse, and means connected to said first terminal for applying a second predetermined voltage to said first terminal; and means for producing an output signal from said second stage amplifier, characterised in that said means for applying said second predetermined voltage produces said second predetermined voltage by comparing a sampled voltage of said output signal with a third predetermined voltage.

According to the invention, a signal charge detector has a clamp circuit between first and second stage amplifiers. After the charge-voltage converter is pre-charged to the first predetermined voltage, the voltage at the input of the second stage amplifier is clamped at the second predetermined voltage by the clamp circuit. The voltage across the first capacitor is fixed at a voltage difference between the clamped voltage, i.e. the first predetermined voltage, and the voltage at the input of the first stage amplifier which is determined by the pre-charge voltage, i.e. the second predetermined voltage. The fixed voltage is added to or subtracted from the voltage generated in response to the signal charges to make the reference voltage of the output signal constant.

In a case where two sets of the charge-voltage converter, the pre-charging circuit, the first stage amplifier, the clamp circuit and the second stage amplifier are used to combine output signals from two charge coupled devices, the reference voltage levels of the output signals may be made equal. In another case where one signal charge detector is used to derive an output from charge coupled device, the dark current component may be removed from the output by selecting the reference voltage level of the output signal adequately.

The invention will now be described, by way of example, with reference to the accompanying drawings, in which:-

Fig. 1 is a circuit diagram of a signal charge detector in the prior art;

Fig. 2 is a timing chart for explaining the operation of the signal charge detector shown in Fig. 1;

Fig. 3 is a timing chart for explaining a drawback of the signal charge detector shown in Fig. 1;

Fig. 4 is a circuit diagram of a signal charge detector according to a first embodiment of the present invention;

Fig. 5 is a timing chart for explaining the operation of the signal charge detector according to the first embodiment of the present invention;

Fig. 6 is an explanatory view of the solid-state imaging device in the prior art;

Figs. 7 and 8 are timing charts for explaining the operation of the solid-state imaging device shown in Fig. 6;

Fig. 9 is a circuit diagram of a signal charge detector according to a second embodiment of the present invention;

Figs. 10 and 11 are timing charts for explaining the operation of the signal charge detector according to the second embodiment of the present invention; and

Fig. 12 is a circuit diagram of a signal charge detector according to a third embodiment of the present invention.

## DESCRIPTION OF THE INVENTION

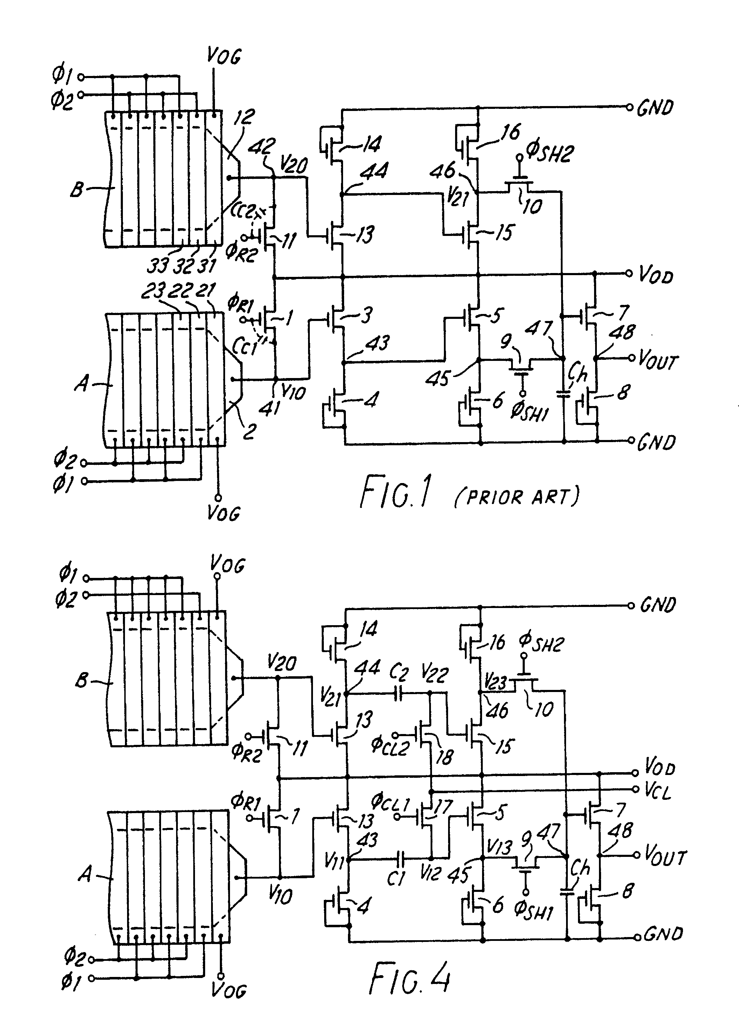

In a linear solid-state imaging device in the prior art, charges generated in alternate photosensors are applied to two charge shift registers A and B, as shown in Fig. 1. After the charges are transferred through the charge shift registers A and B by applying clock pulses $\phi_1$ and $\phi_2$ to gate electrodes 32, 33, 22 and 23, they are introduced to diffusion regions 2 and 12 of the conductivity type opposite to the channel region of the shift registers A and B in accordance with pulses $V_{OG}$ applied to output gates 21 and 31 to convert their charge value to voltage form signals. The voltage form signals are amplified and combined by a MOS FET circuit to obtain a series of output signals. The MOS FET circuit has two sets of a transistor (1, 11) for pre-charging the diffusion regions 2 and 12, a first stage amplifier of transistors 3 and 4 (13 and 14), a second stage amplifier of transistors 5 and 6 (15 and 16) and a sampling transistor 9 (10) and one set of a sampling capacitor $C_h$ and an output amplifier of transistors 7 and 8.

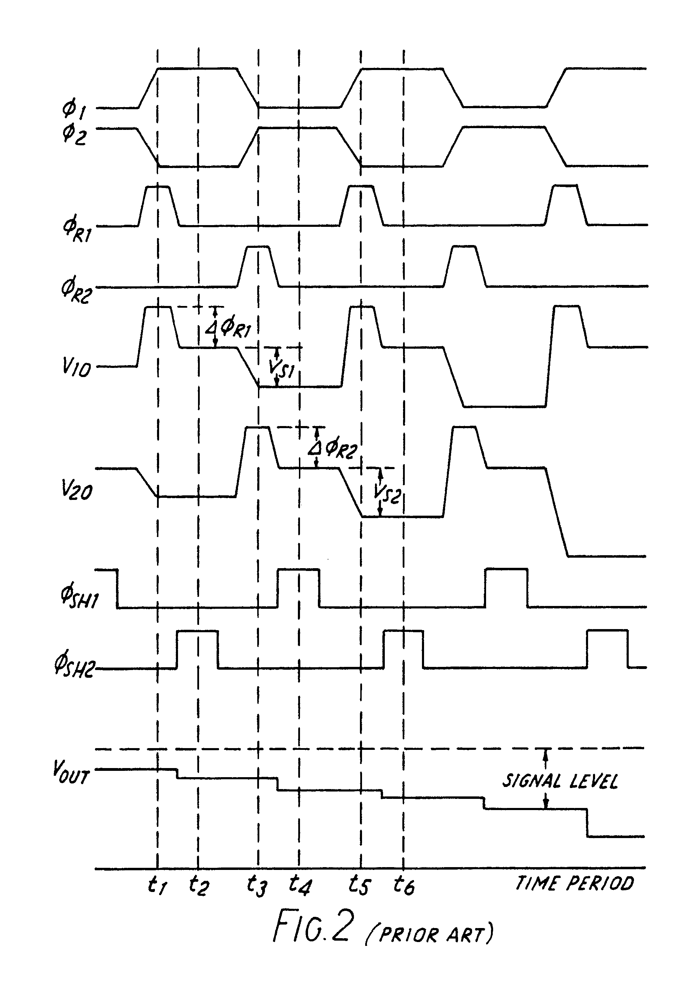

The operation of the MOS FET circuit will be explained with reference to Figs. 1 and 2. First, the transistor 1 is made conductive by a reset pulse $\phi_{R1}$ to precharge the diffusion region 2 (timings $t_1$, $t_5$) and then is made non-conductive by removal of the reset pulse $\phi_{R1}$ (timings $t_2$, $t_6$). The voltage $V_{10}$ at the interconnection 41 rises to $V_{OD}$ at the timings $t_1$, $t_5$. But it drops by the voltage $\Delta\phi_{R1}$ at the timings $t_2$, $t_6$. The gate capacitance $C_{C1}$ of the transistor 1 causes this voltage drop. Thereafter, charges transferred to the portion under the gate electrode 21 are introduced into the diffusion region 2 in response to the application of the pulse $V_{OG}$ to the output gate 21. The voltage $V_{10}$ at the interconnection 41 changes by a value $V_{S1}$ which is proportional to the charge value introduced into the diffusion region 2, at the timing $t_3$. The changed voltage $V_{10}$ is amplified by the first stage amplifier and then by the second stage amplifier. The output from the second stage amplifier is sampled in the sampling capacitor $C_h$ at the timing $t_4$, in response to the application of sampling pulse $\phi_{SH1}$. The sampled voltage is derived as an output signal $V_{out}$ from the output stage amplifier.

The other set of MOS FET circuit in the signal charge detector operates similarly but with a phase different from the above-explained operation. Therefore, the sampling capacitor alternately samples the outputs from two sets of MOS FET circuits. The output signal $V_{out}$ involves alternately the sampled voltage of the output signals from the two MOS FET circuits. Thus, a series of output signals is obtained.

However, one problem arises due to the gate capacitances $C_{C1}$ and $C_{C2}$ of the transistors 1 and 11. As explained above, after the removal of the reset pulses $\phi_{R1}$ and $\phi_{R2}$, the voltages $V_{10}$ and $V_{20}$ respectively drop by the voltages $\Delta\phi_{R1}$ and $\Delta\phi_{R2}$.

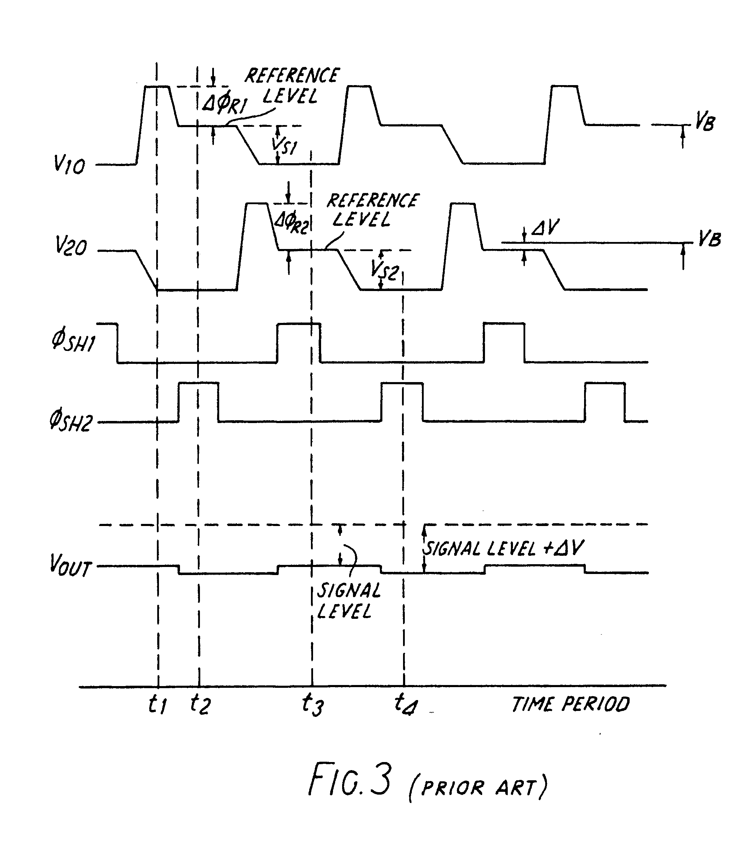

These voltage drops are based on voltages necessary to charge the gate capacitances $C_{C1}$ and $C_{C2}$. Those gate capacitances $C_{C1}$ and $C_{C2}$ are easy to deviate due to manufacturing error. Therefore, the voltages $V_{10}$ and $V_{20}$ after the removal of the reset pulses $\phi_{R1}$ and $\phi_{R2}$ differ from each other by the voltage $\Delta V$, as shown in Fig. 3. This differences causes a change of the output signal $V_{out}$. That is, as shown in Fig. 3, the output signal levels change alternately, even if the signal charges transferred through the shift registers A and B are same.

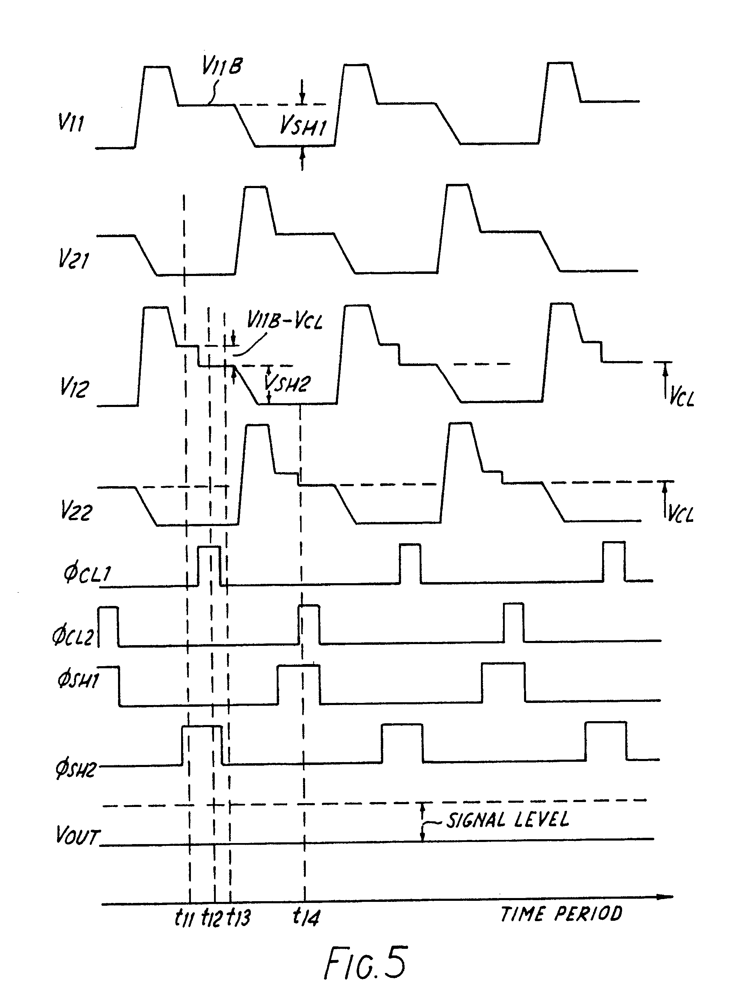

The first embodiment of the present invention shown in Fig. 4 improves this change in output signal level. The same reference numerals are used to the same components as those in the prior art shown in Fig. 1. According to this embodiment, clamp circuits of capacitors $C_1$ and $C_2$ and MOS FET's 17 and 18 are added between the first and second stage amplifiers. The capacitor $C_1$ ($C_2$) is inserted between the output point 43 (44) of the first stage amplifier and the gate of the MOS FET 5 (15) in the second stage amplifier. A source of the MOS FET 17 (18) is connected to the interconnection of the capacitor $C_1$ ($C_2$) and the gate of the MOS FET 5 (15). A clamp voltage $V_{CL}$ is applied to a drain of the MOS FET 17 (18). To gates of the MOS FET's 17 and 18, clamp pulses $\phi_{CL1}$ and $\phi_{CL2}$ are respectively applied.

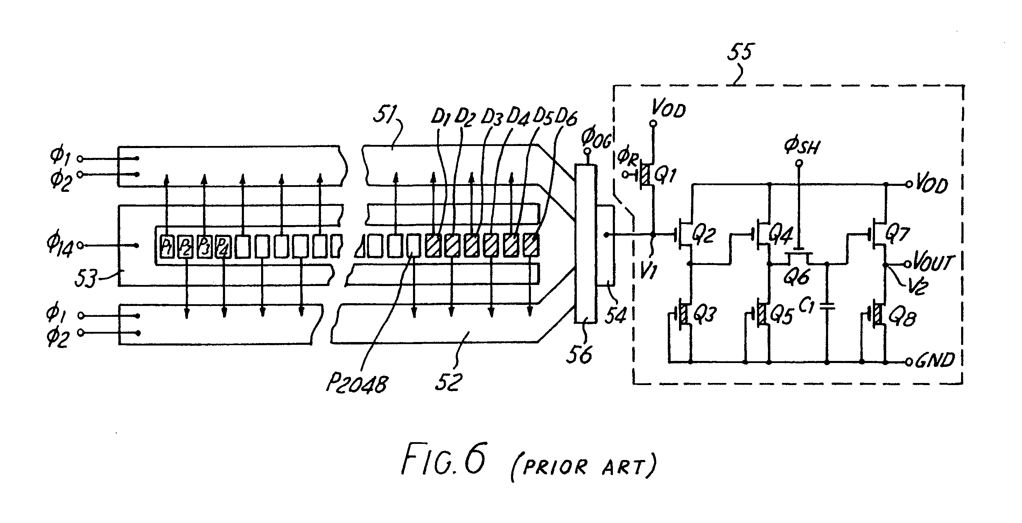

The operation of the first embodiment will be explained with reference to Figs. 4 and 5. After the removal of reset pulse $\phi_{R1}$ (timing $t_{11}$), the clamp pulse $\phi_{CL1}$ is applied to the gate of the MOS FET 17 to clamp the voltage $V_{12}$ at the clamp voltage $V_{CL}$ (timing $t_{12}$). Since the voltage $V_{11}$ at the output point 43 is a voltage level $V_{11B}$, the capacitor $C_1$ is charged by a voltage $V_{11B} - V_{CL}$. Thereafter, the charges transferred through the shift register A are introduced to cause a voltage change in the voltage $V_{11}$ in accordance with signal charge value. The voltage $V_{12}$, accordingly, drops from the clamped voltage $V_{CL}$ by the voltage $V_{SH2}$ which is proportional to the signal charge value. The dropped voltage $V_{12}$ is then sampled in the sampling capacitor $C_h$ by application of the sampling pulse $\phi_{SH1}$ to the transistor 9 (timing $t_{14}$).

The same operation is performed in the other MOS FET circuit with a different phase. In this procedure, although the voltages $V_{11}$ and $V_{12}$ after the removal of the reset pulses $\phi_{R1}$ and $\phi_{R2}$ differ by the difference of gate capacitances $C_{C1}$ and $C_{C2}$ of the transistors 1 and 11, the voltages $V_{12}$ and $V_{22}$ drops from the constant clamp voltage $V_{CL}$ by voltages proportional to the signal charge value. Therefore, the obtained output signal $V_{out}$ has a constant reference level. In other words, when the signal charges are constant, the output signal $V_{out}$ does not change in level and is not affected by the difference of gate capacitances of the transistors 1 and 11.

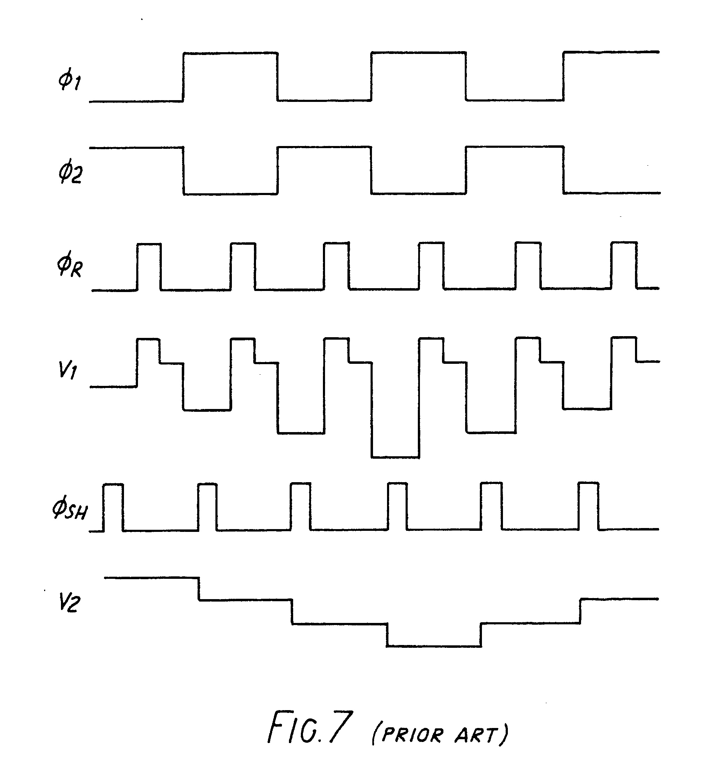

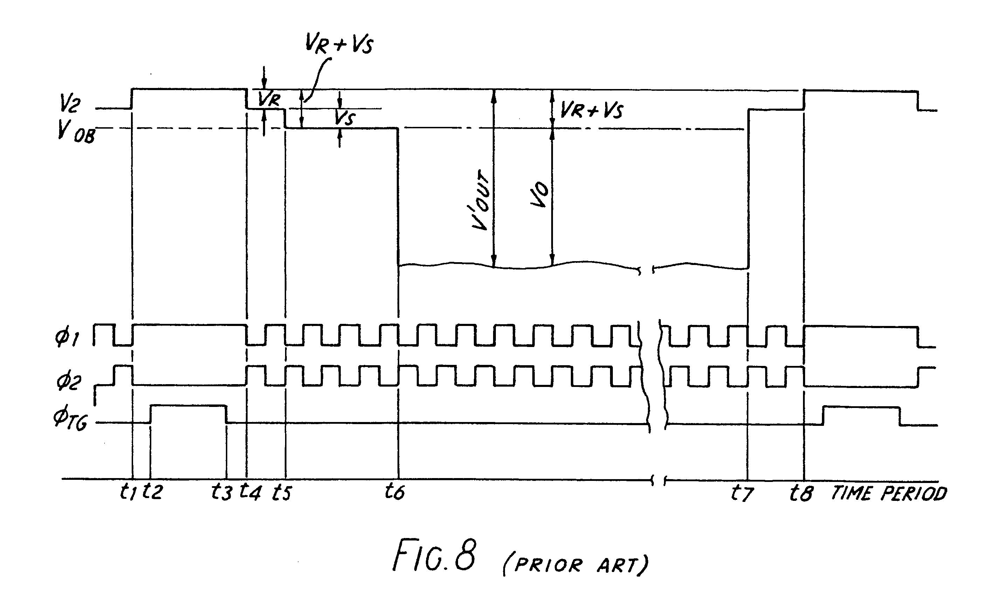

Fig. 6 is another solid-state imaging device in the prior art in which one MOS FET circuit is used as the signal charge detector. A plurality of photosensing elements $P_1$, $P_2$ .... $P_{2048}$ and $D_1$, $D_2$ .... $D_6$ are disposed in a line. The photosensitive element $D_1$, $D_2$ .... $D_4$ are shaded to detect a dark current component. Charges accumulated in alternate photosensitive elements are applied to CCD shift register 51 in response to an application of transfer pulse $\phi_{TG}$ to a transfer gate 53. Charges accumulated in the other photosensitive element are similarly applied to another CCD shift register 52. Charges applied to the CCD shift registers 51 and 52 are transferred therethrough by the clock pulses $\phi_1$ and $\phi_2$. Charges arrived at an output gate 56 are introduced into a diffusion region 54 having a conductivity type opposite to the channel region of the CCD shift registers 51 and 52, in response to the application of a pulse $\phi_{OG}$ to the output gate 56, to convert the charge value to a voltage form signal. The voltage form signal is further applied to a MOS FET circuit 55 to derive an output signal $V_{out}$. This MOS FET circuit 55 has a transistor $Q_1$ receiving a reset pulse $\phi_R$, a first stage amplifier of transistors $Q_2$ and $Q_3$, a second stage amplifier of transistors $Q_4$ and $Q_5$, a sampling circuit of a transistor $Q_6$ receiving a sampling pulse $\phi_{SH}$ and a sampling capacitor $C_1$ and an output stage amplifier of transistors $Q_7$ and $Q_8$, and is similar to the circuit in Fig. 1 consisting of the transistors 1, 3, 4, 5, 6, 7, 8, 9 and the capacitor $C_h$, except for using depletion type FET's as the transistors $Q_1$, $Q_3$, $Q_5$ and $Q_8$. The explanation of basic operation is omitted by showing the timing chart of clock pulses $\phi_1$ and $\phi_2$, reset pulse $\phi_R$, voltage $V_1$ at the gate of the transistor $Q_2$, sampling pulse $\phi_{SH}$ and the voltage $V_2$ at the output terminal, in Fig. 7.

The problem accompanied with the imaging device in the prior art shown in Fig. 6 is based on dark currents flowing in the CCD shift registers 51 and 52 and in the photosensitive elements $P_1$ .... $P_{2048}$ and $D_1$ .... $D_6$. This will be explained with refference to Fig. 8. The voltage $V_2$ is highest during the time period from $t_1$ to $t_4$ when the diffusion region 54 is pre-charged by the reset pulse $\phi_R$. After the removal of the reset pulse $\phi_R$, the shift registers 51 and 52 are operated with the clock pulses $\phi_1$ and $\phi_2$. Thus, charges based the dark current flowing are introduced into the diffusion region 54 to cause a voltage drop $V_R$ in the voltage $V_2$ (period from the timing $t_4$ to timing $t_5$). Following the timing $t_5$, charges accumulated in the shaded photosensitive elements $D_1$ .... $D_6$ are introduced into the diffusion region 54. The charges from the shaded photosensitive elements $D_1$ .... $D_6$ are accumulated in all the photosensitive elements irrespectively of the light radiator, i.e. dark current component and cause a further voltage drop $V_S$ in the voltage $V_2$. From the timing $t_6$ charges accumulated in the photosensitive elements $P_1$ .... $P_{2048}$ are introduced into the diffusion region 54 to cause output $V'_{out}$ at the output terminal. This output $V'_{out}$ involves the voltages $V_R$ and $V_S$ in addition to the voltage $V_0$ based on the signal charges generated in the photosensitive elements $P_1$ .... $P_{2048}$.

The voltage components $V_R$ and $V_S$ must be subtracted from the output $V'_{out}$ by the additional circuit to derive an out $V_0$. However, since the voltages $V_R$ and $V_S$ are based on dark currents which have temperature dependences, the additional circuit must have a very complicated circuit structure. For example, the voltages $V_R$ and $V_S$ become double in response to the temperature increment of $8°$ C.

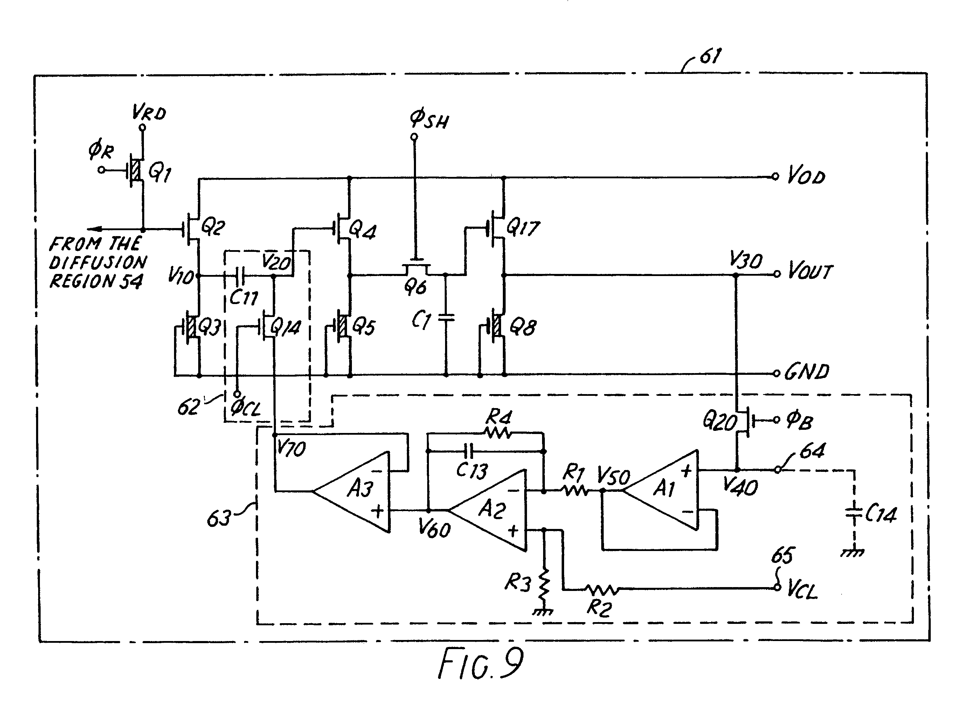

The MOS FET circuit 61 shown in Fig. 9 as a second embodiment of the present invention derives an output signal $V_{out}$ ($V_{30}$) free from the dark current component. The circuit 61 has additional circuit of a clamp circuit 62 and a clamp level control circuit 63, compared to the circuit 55 in the prior art shown in Fig. 6. The gate of the transistor $Q_2$ is connected with the diffusion region 54 of Fig. 6. The clamp circuit 62 is inserted between the first stage amplifier of transistors $Q_2$ and $Q_3$ and the second stage amplifier of transistors $Q_4$ and $Q_5$ and is made of a capacitor $C_{11}$ and a transistor $Q_{14}$. The transistor $Q_{14}$ has a source connected to the gate of the transistor $Q_4$ and the capacitor, a gate receiving a clamp pulse $\emptyset_{CL}$ and a drain connected to the output of the clamp level control circuit 63. The clamp level control circuit 63 has a transistor $Q_{20}$ having a source connected to the output of the output stage amplifier of transistors $Q_7$ and $Q_8$, a gate receiving a pulse $\emptyset_B$, a first differential amplifier $A_1$ having a noninverting input connected to a drain of the transistor $Q_{20}$ and an inverting input and an output connected with each other, a second differential amplifier $A_2$ having an inverting input connected with the output of the first differential amplifier $A_1$ through a resistor $R_1$, a noninverting input receiving a divided voltage of the clamp voltage $V_{CL}$ by the resistors $R_2$ and $R_3$ and an output connected with the inventing input thereof through a parallel circuit of a resistor $R_4$ and a capacitor $C_{13}$ and a third differential amplifier having a noninverting input connected with the output of the second differential amplifier $A_2$ and an inverting input and an output connected with each other. The clamp voltage $V_{CL}$ is applied at the terminal 65. All the differential amplifiers $A_1$, $A_2$ and $A_3$, all the resistors $R_1$, $R_2$, $R_3$ and $R_4$, the transistor $Q_{20}$ and the capacitor $C_{13}$ are formed in a semiconductor integrated circuit. A capacitor $C_{14}$ is added to the integrated circuit through the terminal 64 and connected to the noninverting input of the first differential amplifier $A_1$.

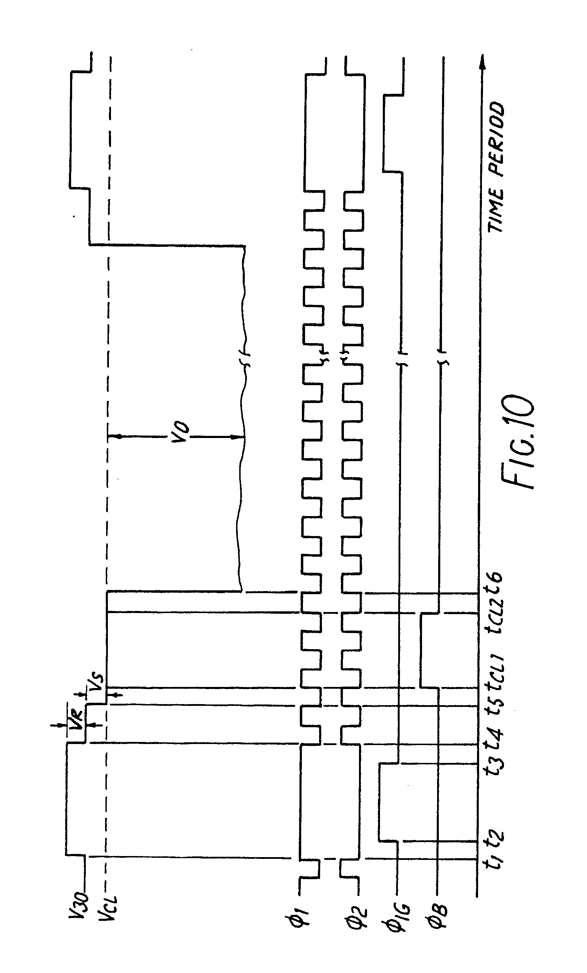

The operation will be next explained with reference to Fig. 10. The diffusion region 54 (Fig. 6) is precharged at the timing $t_1$. The charges accumulated in photosensitive elements $P_1$ .... $P_{2048}$ and $D_1$ .... $D_6$ are applied to the CCD shift registers 51 and 52 in the period from the timing $t_2$ to the timing $t_3$. The pre-charging terminates at the timing $t_4$. At she same time, the charge transfer through the CCD shift registers 51 and 52 starts. In the time period until the charges from the shaded photosensitive elements $D_1$ .... $D_6$ are introduced into the diffusion region 54, the voltage $V_{30}$ at the output terminal drops the voltage $V_R$ due to the dark currents flowing through the CCD shift registers 51 and 52. The charges from the shaded photosensitive elements begin to be introduced into the diffusion region 54 at the timing $t_5$ and the voltage $V_{30}$ further drops by the voltage $V_S$ due to the dark current in the photosensitive elements.

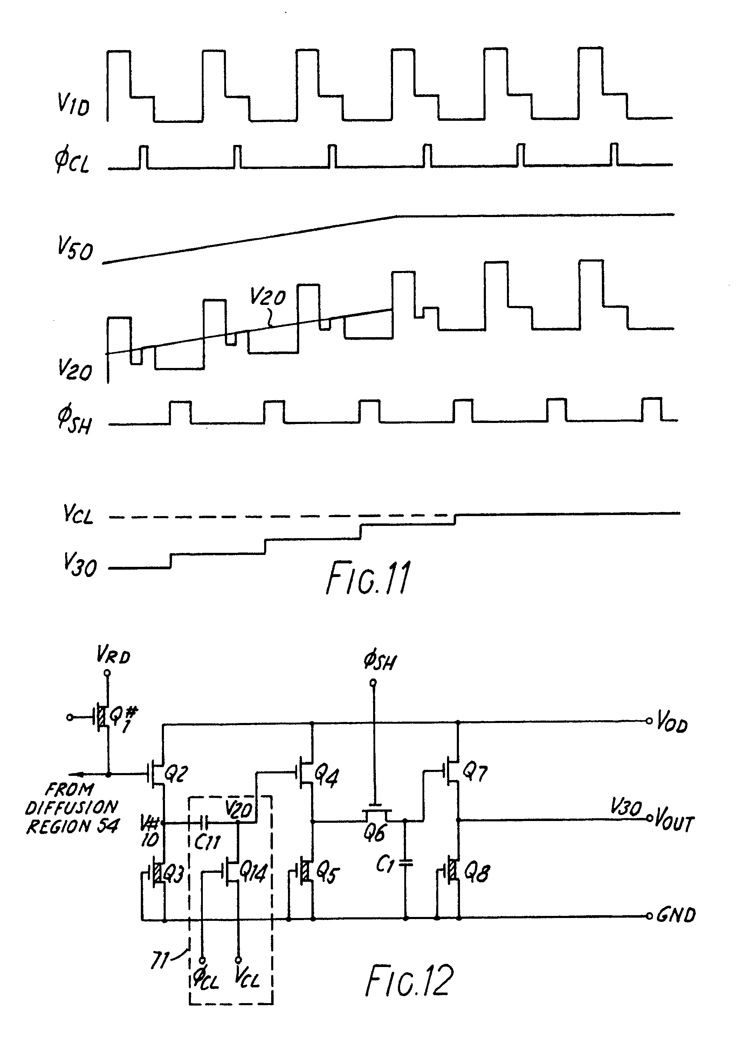

The pulse $\emptyset_B$ is applied to the transistor $Q_{20}$ in the time period from the timing $t_{d1}$ to the timing $t_{d2}$ to charge the capacitor $C_{14}$. Here, the operation of the clamp level control circuit 63 will be explained with reference to Fig. 11. As a result of the application of the pulse $\emptyset_B$, the voltage $V_{40}$ at the terminal 64 becomes the same voltage as the voltage $V_{30}$. Since the output and the inverting input of the first differential amplifier $A_1$ is directly connected, the voltage $V_{50}$ at the output thereof becomes the same voltage as the voltage $V_{40}$. That is, the voltages $V_{30}$ and $V_{50}$ become same. The voltage $V_{50}$ is compared with the clamp voltage $V_{CL}$ by the first differential amplifier A2. If the voltage $V_{50}$, i.e. the voltage $V_{30}$, is lower than the clamp voltage $V_{CL}$, the voltage $V_{60}$ at the output of the second differential amplifier $A_2$ rises. The same voltage appears at the output of the third differential amplifier $A_3$ as the voltage $V_{70}$. In response to the clamp pulse $\emptyset_{CL}$, the voltage $V_{30}$ is clamped at the voltage $V_{70}$. Due to the clamp, the voltage $V_{30}$ is rised at the time of next sampling pulse $\emptyset_{SH}$. If the rised voltage $V_{30}$ is still lower than the clamp voltage $V_{CL}$, the above operation is repeated until the voltages $V_{30}$ and $V_{CL}$ become equal. The gain of the second differential amplifier $A_2$ is designed so that the voltages $V_{30}$ and $V_{CL}$ may become equal within the time period from the timing $t_{d1}$ to the timing $t_{d2}$ which equals the pulse width of the pulse $\emptyset_B$. Such gain control is easily achieved by controlling the resistance of the resistor $R_4$.

On the contrary, if the voltage $V_{30}$ is higher than the clamp voltage $V_{CL}$, the voltage $V_{70}$ has a lower voltage and the voltage $V_{20}$ is clamped to this lower voltage $V_{70}$. As a result, the voltage $V_{30}$ decreases and finally becomes the same voltage as the clamp voltage $V_{CL}$.

Under the condition where the voltage $V_{30}$ is clamped to the clamp voltage $V_{CL}$, the charges from the photosensitive elements $P_1$ .... $P_{2048}$ are introduced into the diffusion region 54 from the timing $t_6$. Therefore, the voltage $V_{30}$ changes from the clamp voltage $V_{CL}$ in accordance with the charges from the photosensitive elements $P_1$ .... $P_{2048}$. The voltage difference of the voltage $V_{30}$ from the clamp voltage $V_{CL}$ is proportional to the signal charge value, irrespective of the voltages $V_R$ and $V_S$ due to dark currents.

The third embodiment of the present invention shown in Fig. 12 does not clamp the output voltage $V_{30}$ to the clamp voltage $V_{CL}$, but clamps the voltage $V_{20}$ at the gate of the transistor $Q_4$ in the second stage amplifier to the clamp voltage $V_{CL}$. The clamp circuit 71 is added to the circuit in the prior art shown in Fig. 6. Compared to the second embodiment shown in Fig. 9, the clamp level control circuit 63 is omitted. The clamp circuit 71 has a capacitor $C_{11}$ and a transistor $Q_{14}$. The clamp voltage $V_{CL}$ is applied to the drain of the transistor $Q_{14}$. The clamp pulse $\phi_{CL}$ is applied to the gate of the transistor $Q_{14}$ at the time period from the timing $t_{CL1}$ to the timing $t_{CL2}$ as shown in Fig. 10. As a result, the voltage $V_{20}$ is clamped at the clamp voltage $V_{CL}$. Following such voltage clamp, the charges from the photosensitive elements $P_1$ .... $P_{2048}$ are introduced into the diffusion region 54 (Fig. 6). The voltage $V_{20}$ changes from the above clamped voltage $V_{CL}$ in accordance with the signal charges accumulated in the photosensitive elements $P_1$ .... $P_{2048}$. Therefore, the output voltage $V_{30}$ changes from some voltage corresponding to the clamp voltage $V_{CL}$ by a value corresponding to the signal charge value.

According to the third embodiment, the output signal having a fixed reference level is obtained with a simple circuit. The fixed reference level may be adjusted by controlling the clamp voltage $V_{CL}$. Therefore, the circuit is preferably applicable to control the black level in facsimile equipment.

Although the above-explained embodiments are examples applying the present invention to solid-state linear imaging devices, the present invention is equally applicable to solid-state area imaging devices. The transistor elements may be either N-type or P-type.

## Claims

1. A signal charge detector comprising: a charge-voltage converter for receiving charges and producing a signal of voltage form; means for charging said charge-voltage converter to a first predetermined voltage; a first stage amplifier having an input connected to said charge-voltage converter and to said charging means and an output; a second stage amplifier having an input and an output; a clamp circuit connected between said output of said first stage amplifier and said input of said second stage amplifier, said clamp circuit having a capacitor connected between said output of said first stage amplifier and said input of said second stage amplifier, switching means connected between said input of said second stage amplifier and a first terminal for closure in response to a clamping pulse, and means connected to said first terminal for applying a second predetermined voltage to said first terminal; and means for producing an output signal from said second stage amplifier, characterised in that said means for applying said second predetermined voltage produces said second predetermined voltage by comparing a sampled voltage of said output signal with a third predetermined voltage.

2. A signal charge detector as claimed in claim 2, characterised in that said switching means is a transistor having a control electrode connected to a second terminal to receive said clamping pulse and providing an electrical path between said input of said second stage amplifier and said first terminal, the conductivity of said electrical path being controlled by said clamping pulse.

3. A signal charge detector as claimed in claim 1 or 2, characterised in that said means for applying said second predetermined voltage comprises means for sampling said output signal to produce said sampled voltage, means for producing said third predetermined voltage, means for comparing said sampled voltage with said third predetermined voltage, and means for producing said second predetermined voltage in accordance with the output from said comparing means.

## Revendications

1. Détecteur de charges par signal comprenant : un convertisseur de tension de charges pour recevoir des charges et produire un signal sous forme de tension; un moyen pour charger le convertisseur de tension de charges à une première tension prédéterminée; un amplificateur d'un premier étage ayant une entrée connectée au convertisseur de tension de charges et au moyen de charge et une sortie; un amplificateur de second étage ayant une entrée et une sortie; un circuit de fixation monté entre la sortie de l'amplificateur du premier étage et l'entrée de l'amplificateur du second étage, le circuit de fixation ayant un condensateur connecté entre la sortie de l'amplificateur du premier étage et l'entrée de l'amplificateur du second étage, un moyen de commutation connecté entre l'entrée de l'amplificateur du second étage et une première borne pour fermeture en réponse à une impulsion de fixation, et un moyen connecté à la première borne afin d'appliquer une seconde tension prédéterminée à la première borne; et un moyen pour produire un signal de sortie provenant de l'amplificateur du second étage, caractérisé en ce que le moyen pour appliquer la seconde tension prédéterminée produit cette seconde tension prédéterminée en comparant une tension échantillonnée du signal de sortie à une troisième tension prédéterminée.

2.   Détecteur de charges par signal selon la revendication 2, caractérisé en ce que le moyen de commutation est un transistor ayant une électrode de commande connectée à une seconde borne de manière à recevoir l'impulsion de fixation et fournissant un trajet électrique entre l'entrée de l'amplificateur du second étage et la première borne, la conductivité du trajet électrique étant contrôlée par l'impulsion de fixation.

3.   Détecteur de charges par signal selon la revendication 1 ou 2, caractérisé en ce que le moyen pour appliquer la seconde tension prédéterminée comprend un moyen pour échantillonner le signal de sortie afin de produire la tension échantillonnée, un moyen pour produire la troisième tension prédéterminée, un moyen pour comparer la tension échantillonnée à la troisième tension prédéterminée, et un moyen pour produire la seconde tension prédéterminée en conformité avec la sortie du moyen de comparaison.

## Ansprüche

1.   Signalladungsdetektor, umfassend einen Ladungs-Spannungskonverter zum Empfangen von Ladungen und zum Erzeugen von Signalen in Spannungsform; eine Einrichtung zum Laden des Ladungsspannungskonverters auf eine erste vorgegebene Spannung; eine erste Verstärkerstufe, die einen mit dem Ladungsspannungskonverter und mit der Ladeeinrichtung verbundenen Eingang und einen Ausgang aufweist; eine zweite Verstärkerstufe, mit einem Eingang und einem Ausgang; eine Klemmschaltung, die zwischen den Ausgang der ersten Verstärkerstufe und den Eingang der zweiten Verstärkerstufe geschaltet ist, wobei die Klemmschaltung aufweist: Einen Kondensator, der zwischen den Ausgang der ersten Verstärkerstufe und den Eingang der zweiten Verstärkerstufe geschaltet ist, eine Schaltelementeinrichtung, die zwischen den Eingang der zweiten Verstärkerstufe und einem ersten Anschluß geschaltet ist und in Abhängigkeit von einem Klemmimpuls schließen, und eine mit dem ersten Anschluß verbundene Einrichtung zum Aufbringen einer zweiten vorgegebenen Spannung auf den ersten Anschluß, und Mittel zum Erzeugen eines Ausgangssignals der zweiten Verstärkerstufe, dadurch **gekennzeichnet,** daß die Mittel zum Aufbringen der zweiten vorgegebenen Spannung diese zweite vorgegebene Spannung durch Vergleich einer abgetasteten Spannung des Ausgangssignals mit einer dritten vorgegebenen Spannung erzeugen.

2.   Signalladungsdetektor gemäß Anspruch 1, dadurch **gekennzeichnet,** daß die Schalteinrichtung ein Transistor ist, der eine Steuerelektrode aufweist, die verbunden ist mit einem zweiten Anschluß zum Empfangen des Klemmimpulses und zum Herstellen eines elektrischen Weges zwischen dem Eingang der zweiten Verstärkerstufe und dem ersten Anschluß, wobei die Leitfähigkeit des elektrischen Weges von dem Klemmimpuls gesteuert wird.

3.   Signalladungsdetektor gemäß den Ansprüchen 1 oder 2, dadurch **gekennzeichnet,** daß die Einrichtung zum Aufbringen der zweiten vorgegebenen Spannung Mittel zum Abtasten des Ausgangssignals zum Erzeugen der abgetasteten Spannung, Mittel zum Erzeugen der dritten vorgegebenen Spannung, Mittel zum Vergleichen der abgetasteten Spannung mit der dritten vorgegebenen Spannung und Mittel zum Erzeugen der zweiten vorgegebenen Spannung entsprechend dem Ausgang der Vergleichseinrichtung umfaßt.

FIG.1 (PRIOR ART)

FIG.4

FIG.2 (PRIOR ART)

FIG.3 (PRIOR ART)

FIG.5

FIG. 6 (PRIOR ART)

FIG. 7 (PRIOR ART)

FIG.8 (PRIOR ART)

FIG.9

EP 0 143 600 B1

FIG.10

FIG.11

FIG.12